# EUROPÄISCHE PATENTSCHRIFT

(11) **EP 3 492 881 B1**
(45) Veröffentlichungstag und Bekanntmachung des Hinweises auf die Patenterteilung: **26.02.2020**
(21) Anmeldenummer: 17205156.7
(22) Anmeldetag: 04.12.2017
(51) Int. Cl.: G01S 7/03, G01S 7/02, G01F 23/284, H01P 5/107, G01S 13/88

(54) **LEITERPLATTE FÜR EIN RADAR-FÜLLSTANDMESSGERÄT MIT HOHLLEITEREINKOPPLUNG**
PRINTED CIRCUIT BOARD FOR USE IN A RADAR FILL LEVEL MEASURING DEVICE WITH HOLLOW WIRE COUPLING
CARTE DE CIRCUITS IMPRIMÉS POUR UN APPAREIL DE MESURE DE NIVEAU DE REMPLISSAGE RADAR POURVUE DE COUPLAGE DU GUIDE D'ONDE

(43) Veröffentlichungstag der Anmeldung: 05.06.2019
(73) Patentinhaber: VEGA Grieshaber KG, 77709 Wolfach (DE)
(72) Erfinder: MOTZER, Jürgen, 77723 Gengenbach (DE); RAUER, Winfried, 77716 Fischerbach (DE); SCHULTHEISS, Daniel, 78132 Hornberg (DE); MÜLLER, Christoph, 77728 Oppenau (DE)
(74) Vertreter: Maiwald Patent- und Rechtsanwaltsgesellschaft mbH

(56) Entgegenhaltungen:
- EP-B1- 1 949 491
- DE-A1-102015 119 690
- DE-T5-112010 003 585

## Beschreibung

### Technisches Gebiet

Die vorliegende Erfindung betrifft die Messung von Füllständen, beispielsweise in Behältern. Insbesondere betrifft die Erfindung eine Leiterplatte für ein mikrowellenbasiertes oder radarbasiertes Füllstandmessgerät mit einer Einkopplung von Mikrowellen in einen Hohlleiter.

### Hintergrund der Erfindung

Bekannte Füllstandmessgeräte nutzen in zunehmendem Maße Prinzipien, die auf der Ausbreitung elektromagnetischer Wellen bzw. ein Reflexionsverhalten und Laufzeitverhalten dieser Wellen zur Bestimmung von Füllständen benutzen. Dabei wird eine hochfrequente elektromagnetische Welle, beispielsweise ein Mikrowellenpuls von einem Füllstandmessgerät in Richtung einer Oberfläche eines Füllgutes in einem Behälter ausgesendet, von dieser Oberfläche reflektiert und auf Basis der Laufzeiten des reflektierten Mikrowellensignals ein Füllstand berechnet. Durch technische Weiterentwicklungen, insbesondere der Elektronik und der Halbleitertechnologie, werden zunehmend auch höhere Frequenzen im oberen zweistelligen Gigahertzbereich zu Füllstandmessungen genutzt. Durch die hohen Frequenzen und die daraus resultierenden physikalischen Eigenschaften der Wellenausbreitung steigen die Anforderungen an insbesondere die Hochfrequenzbauteile solcher Füllstandmessgeräte. Häufig wird hierbei die Hochfrequenzbaugruppe auf einer Leiterplatte realisiert, die die Elektronik für die Erzeugung der Mikrowellenpulse sowie die Antennentechnik beinhaltet.

Eine Möglichkeit, die erzeugten hochfrequenten Schwingungen weiterzuleiten, beispielsweise an eine externe Antenne, besteht im Anschluss eines Hohlleiters. Diese Hohlleiter sind im verwendeten Frequenzbereich vorteilhaft zum Weiterleiten von Mikrowellensignalen einsetzbar. Eine besondere Herausforderung liegt im Hohlleiterübergang, also der Abstrahlung der elektromagnetischen Welle von einem Leiter (z.B. auf der Leiterplatte) in das Innere eines Hohlleiters und umgekehrt. Dieser Leiter kann beispielsweise als Mikro-Strip ausgeführt sein, dessen Ende in einen Hohlleiter hineinragt. Die Hohlleiter können beispielsweise als Lufthohlleiter ausgeführt sein.

Um elektrische Verluste und eine gute Anpassung zu erreichen, können hierbei besondere technische Vorkehrungen notwendig sein. So muss beispielsweise der Hohlleiter an seinem Ende zur verlustarmen oder verlustfreien Einkopplung des Signals einen Resonator aufweisen, dessen Größe, Durchmesser und geometrische Ausführung die Verluste im Bereich der verwendeten Frequenzen minimiert. Gleichzeitig ist es wünschenswert, die Größe der Baugruppen zu verkleinern und einen Aufbau bei gleichzeitig hoher Qualität zu vereinfachen. Ein technischer Lösungsansatz kann darin bestehen, die verschiedenen Funktionen möglichst zu integrieren und so einfache und preisgünstige Baugruppen zu erhalten. So ist beispielsweise aus der EP 1 949 491 B1 ein Hohlleiterübergang bekannt, bei dem der Resonator des Hohlleiters in die Leiterplatte integriert ist.

### Darstellung der Erfindung

Ausführungsformen der Erfindung können eine mechanische Stabilität und elektromagnetische Zuverlässigkeit und Genauigkeit eines radarbasierten oder mikrowellenbasierten Füllstandmessgerätes erhöhen. Der im Folgenden beschriebenen Erfindung liegen die folgenden Überlegungen zugrunde: Bei den derzeit bekannten Lösungen wird ein Resonator, der häufig topfförmig ausgestaltet ist, benötigt. Gleichzeitig besteht die Notwendigkeit, diesen Resonator räumlich unmittelbar am Ende des Hohlleiters anzuordnen, um einen verlustfreien oder verlustarmen Abschluss des Hohlleiters zu realisieren. Wird nun der Hohlleiter üblicherweise in einem Winkel von 90° an die Leiterplatte herangeführt, ergibt sich die Notwendigkeit, den Resonator in Richtung eines Substrates der Leiterplatte einzuarbeiten. Im Stand der Technik wird dies beispielsweise dadurch realisiert, dass eine Vertiefung oder Einfräsung in eine Schicht des Leiterplattensubstrates in Verlängerung des Hohlleiters eingebracht wird, die dann, um Verunreinigungen zu vermeiden, meist mit einer Abdeckung aus HF-Substrat oder einem Kunststoffdeckel verschlossen werden muss. Dies kann Nachteile hinsichtlich der elektrischen, elektromagnetischen und mechanischen Eigenschaften der Leiterplatte haben.

Als Lösung hierfür wird eine Leiterplatte für ein Radar-Füllstandmessgerät vorgeschlagen, die ein nichtleitendes flächiges Leiterplattensubstrat als Trägermaterial aufweist. Neben der Funktion als mechanische Stabilisierung und Trägerfunktion ist das Leiterplattensubstrat isolierend für den verwendeten Frequenzbereich der elektromagnetischen Wellen ausgeführt. Dies kann beispielsweise ein sogenanntes HF-Substrat sein. Auf dem Leiterplattensubstrat ist ein Mikrowellenleiter zur Einkopplung eines Mikrowellensignals in einen Hohlleiter angeordnet. Dies kann beispielsweise als Mikro-Strip-Leiter ausgeführt sein. In einem Beispiel ist dieser auf der Oberfläche des Leiterplattensubstrates angeordnet. In einem weiteren Beispiel verläuft der Mikrowellenleiter zumindest teilweise in einem Inneren des Leiterplattensubstrates.

Auf einer Vorderseite des Leiterplattensubstrates ist ein umlaufender, also ringförmiger, beispielsweise runder oder eckiger, Verbindungsbereich zur Aufnahme eines stirnseitigen Endes eines Hohlleiters angeordnet. In den meisten Fällen ist das Leiterplattensubstrat beispielsweise als Trägerplatte oder Grundplatte ausgeführt, wobei es sich oft um einen Verbund aus HF-Substrat und einem Grundträger (z.B. FR4) handelt. Durch diese flächige Ausführung kann eine Vorderseite definiert werden, die beispielsweise Bauelemente aufweisen kann. Entsprechend ist eine Rückseite oder Unterseite häufig für Kontaktierungen und Anschlüsse vorgesehen.

Unter einem ringförmigen Verbindungsbereich ist mit anderen Worten ein Bereich auf der Vorderseite des Leiterplattensubstrates gemeint, der beispielsweise direkt mit dem Hohlleiter, oder auch mit einer Wandung eines Hohlleiters in Berührung kommt oder eine entsprechende mechanische Aufnahme erlaubt. Unter ringförmig ist hier zu verstehen, dass dieser Bereich sich zumindest teilweise in seiner generellen Ausformung an eine Querschnittsform des Hohlleiters anpasst. Ist eine Querschnittsform des Hohlleiters beispielsweise kreisförmig, so ist der Verbindungsbereich ebenfalls in etwa kreisförmig nachgebildet.

In einem Beispiel ist der Verbindungsbereich rechteckig ausgeführt, um einen Hohlleiter mit rechteckigem Querschnitt aufzunehmen. Der Hohlleiter kann durch entsprechende mechanische Mittel oder auch in Kombination mit elektrischer Kontaktierung mechanisch befestigt werden. Hierzu kann der Hohlleiter am Verbindungsbereich beispielsweise angeklebt, angeschraubt oder angelötet werden.

Ein Ende des Mikrowellenleiters ragt in den Verbindungsbereich hinein, sodass Mikrowellensignale vom Mikrowellenleiter in den Hohlleiter übergehen können und umgekehrt. In einem Beispiel befindet sich ein Ende des Mikrowellenleiters in etwa in der Mitte des Querschnittes des Hohlleiters. Mit anderen Worten funktioniert das Ende des Mikrowellenleiters wie eine Antenne, die die Mikrowellensignale in den Hohlleiter abstrahlt bzw. von diesem empfängt. In einem Beispiel wird der Mikrowellenleiter innerhalb des Leiterplattensubstrates geführt, wodurch sich die Herstellung einer separaten Aussparung zur isolierten Durchführung des Mikrowellenleiters am Ende des Hohlleiters erübrigen kann.

Auf einer Rückseite des Leiterplattensubstrates ist gegenüber dem ringförmigen Verbindungsbereich eine, beispielsweise der Querschnittsfläche des Hohlleiters entsprechende und ringförmige, umlaufende Eintiefung in Richtung des Hohlleiters angeordnet. Grundsätzlich kann die Querschnittsfläche des Verbindungsbereichs im Vergleich zur Querschnittsfläche des Hohlleiters einen Sprung machen, da der hintere Bereich mit einem Dielektrikum gefüllt ist und somit kleiner sein könnte.

Mit anderen Worten verläuft die Eintiefung auf der Rückseite des Leiterplattensubstrates gegenüber dem Bereich, wo eine Wandung des Hohlleiters an die Vorderseite des Leiterplattensubstrates angrenzt. Ziel soll hier sein, einen Abstand zwischen einer Fläche der Rückseite des Leiterplattensubstrates und dem Hohlleiter zu verringern. Dies sollte über einen möglichst großen Bereich der Wandung des Hohlleiters, idealerweise über seinen gesamten Bereich geschehen. Die hierdurch entstehende Struktur bildet in etwa eine topfförmige Form aus, die letztendlich die Form eines Resonators bzw. eines Resonatortopfes bildet. Mit anderen Worten wird hier entgegen den bekannten Lösungen die geometrische Form eines Resonators als negative Formen bzw. invers, also über die Rückseite des Leiterplattensubstrates erzeugt.

Die Eintiefung muss nicht notwendigerweise eine geschlossene Form aufweisen, sondern es sind auch verschiedenste Formen wie Nute, Kerben, Spalte und Ähnliches denkbar. Auch ist es nicht zwingend notwendig, eine geschlossene Ringform zu implementieren, sondern die Eintiefung kann gemäß einem Beispiel aus mehreren Teilstücken, Teilbögen oder einer Kombination aus verschiedenen Formen bestehen.

In einem Beispiel ist die Eintiefung als offener Kreisbogen oder auch als offene Rechteckform ausgeführt.

Der von der Wandung der Eintiefung und ein von der Eintiefung umgebener Bereich der Rückseite des Leiterplattensubstrates weist eine für Mikrowellen reflektierende Beschichtung auf, sodass diese zusammen einen Resonator für die eingekoppelten Mikrowellensignale bilden. Mit anderen Worten wird durch die Eintiefung und den von dieser Eintiefung umgebenen Bereich eine in etwa topfartige Form, also ein so genannter Resonatortopf als elektromagnetischer Abschluss des Hohlleiters, gebildet. Zusammen mit der reflektierenden Beschichtung ergibt sich durch die geometrische Form und die Abmessungen eine Resonanz im relevanten Frequenzbereich. In einem Beispiel sind die Beschichtung in der Eintiefung und die Beschichtung im von der Eintiefung umgebenen Bereich miteinander verbunden. In einem weiteren Beispiel sind die Beschichtung in der Eintiefung und die Beschichtung im umgebenen Bereich voneinander getrennt.

In einer Ausführungsform der Erfindung ist die reflektierende Beschichtung als metallische Beschichtung ausgeführt. Metallische Beschichtungen können aus verschiedenen Materialien hergestellt werden, vorzugsweise gut leitende Metalle, um den elektromagnetischen und reflektierenden Effekt zu erreichen. Vorteil metallischer Beschichtungen kann eine gute Kontaktierbarkeit und Haltbarkeit sein. In einer weiteren Ausführungsform sind im Bereich der Eintiefung Durchkontaktierungen zwischen der Vorderseite und der metallischen Beschichtung angeordnet, sodass die metallische Beschichtung mit dem Hohlleiter elektrisch verbindbar ist. Mit anderen Worten wird eine elektrische Verbindung zwischen dem Resonatortopf und einer beispielsweise metallisch ausgeführten Wandung des Hohlleiters hergestellt.

Über die Durchkontaktierungen kann eine elektrische Verbindung auf die jeweils andere Seite des Leiterplattensubstrates geschaffen werden. Dabei kann durch die beispielsweise als elektrisch leitende und metallisierte Bohrung ausgeführten Durchkontaktierungen gleichzeitig die Stabilität des Leiterplattensubstrates erhalten bleiben und gleichzeitig eine ausreichende Güte der elektrischen Verbindung erreicht werden. Auf der Vorderseite kann eine Verbindung zwischen den Durchkontaktierungen und dem Hohlleiter beispielsweise über Schweißverbindungen oder Lötverbindungen hergestellt werden.

In einer Ausführungsform der Erfindung ist ein Abstand zwischen zwei benachbarten Durchkontaktierungen kleiner als ein Viertel der Wellenlänge der Mikrowellen. Dies kann vorteilhaft eine Ausbreitung der Mikrowellen aus einem Innenbereich des Hohlleiters bzw. einem Innenbereich des Verbindungsbereiches in Bereiche außerhalb des Hohlleiters verhindern. Sozusagen wirken die jeweils benachbart angeordneten Durchkontaktierungen elektromagnetisch insgesamt wie eine durchgängige Sperre für die Mikrowellen.

In einer Ausführungsform der Erfindung ist der von der Eintiefung eingeschlossene Bereich der Rückseite in Richtung der Vorderseite abgesenkt. Beispielsweise kann dies durch mechanisches Abtragen dieses Bereiches erfolgen. Hierdurch verringert sich ein Abstand dieses Bereiches mit der für Mikrowellen reflektierenden Beschichtung zum Hohlleiter. Durch einen Grad der Absenkung kann beispielsweise eine elektromagnetische Abstimmung des Resonatortopfes auf die verwendeten Frequenzen erfolgen. In einer weiteren Ausführungsform sind die Eintiefung und/oder der von der Eintiefung eingeschlossene Bereich mit einem Kunstharz gefüllt. Dies kann den Vorteil haben, dass durch das Vergießen die ursprüngliche Dicke des Leiterplattensubstrates wiederhergestellt werden kann und somit eine erhöhte mechanische Stabilität des gesamten Leiterplattensubstrates und der Leiterplatte erreicht werden kann. Ohne diese Verfüllung kann der Resonatortopf über die stehenbleibende Leiterplattenschicht mechanisch gehalten werden. Ob dies praktikabel ist, entscheidet beispielsweise das Maß der Eintiefung.

Das Absenken des Bereiches, der von der Eintiefung umgeben ist, kann so zusätzlich das Aufnehmen einer Schicht aus Kunstharz in dem abgetragenen Bereich ermöglichen und so zusätzliche Stabilität in Verbindung mit dem in der Eintiefung eingebrachten Kunstharz erzeugen. In einem Beispiel erfolgt eine Füllung mit Kunstharz derart, dass eine ursprüngliche plane Oberflächengestalt der Rückseite des Leiterplattensubstrates wieder erzeugt wird.

In einer Ausführungsform der Erfindung sind der Verbindungsbereich und die Eintiefung rechteckig ausgestaltet. Dies kann den Vorteil haben, dass auch von einem kreisförmigen oder ringförmigen Hohlleiter auf rechteckig ausgestaltete Querschnitte von Hohlleitern zurückgegriffen werden kann. Entsprechend wird in einer weiteren Ausführungsform der Erfindung eine kreisförmige Ausgestaltung dieses Verbindungsbereiches und der Eintiefung vorgeschlagen. Dabei kann gemäß einer weiteren Ausführungsform der Erfindung die Leiterplatte mehrere Leitungsebenen aufweisen, die beispielsweise aus Kupfer hergestellt sein können.

Gemäß einer weiteren Ausführungsform ist die Leiterplatte als Land Grid Array oder Ball Grid Array ausgeführt. Dies kann beispielsweise bedeuten, dass Kontaktpads auf einer Rückseite des Leiterplattensubstrates zur Kontaktierung mit weiteren Bauteilen und Baugruppen vorgesehen sind. Dies kann weiterhin vorteilhaft eine Ausführung der Leiterplatte in SMD-Bauweise ermöglichen. Gemäß einem Beispiel sind Anschlüsse der Leiterplatte bzw. des Leiterplattensubstrates auf die Rückseite des Leiterplattensubstrates geführt und an Kontaktpads angeschlossen. Diese können beispielsweise über Lötverbindungen weitere Baugruppen verbinden.

Gemäß einer weiteren Ausführungsform weist die Leiterplatte mehrere Leitungsebenen auf.

Gemäß einem weiteren Beispiel ist das Leiterplattensubstrat mit einem Kunststoff umgeben. Dieser Kunststoff kann vorteilhaft Funktionen eines Gehäuses abbilden und gleichzeitig Stabilität und geringe Baugröße erreichen. Gemäß einem weiteren Beispiel ist das Leiterplattensubstrat so von dem Kunststoff umgeben, dass der Verbindungsbereich ausgespart ist. Dadurch kann erreicht werden, dass trotz des umgebenden Kunststoffes ein elektrischer Kontakt und mechanischer Kontakt des Hohlleiters mit den Durchkontaktierungen bzw. mit dem Leiterplattensubstrat ermöglicht wird.

Gemäß einer Ausführungsform der Erfindung weist die Leiterplatte auf der Vorderseite des Leiterplattensubstrates eine zweite Eintiefung zur Aufnahme eines Hochfrequenzchips (HF-Chips) auf, wobei der Mikrowellenleiter zwischen der zweiten Eintiefung und dem Verbindungsbereich verläuft. In dieser zweiten Eintiefung wird der Halbleiterchip platziert und anschließend mit einem sogenannten Glob-Top oder einem Deckel verschlossen.

Durch das Führen des Mikrowellenleiters auf oder innerhalb des Leiterplattensubstrates bis in den Innenbereich des Hohlleiters ist diese Anordnung gut geeignet, dass Mikrowellensignale von einem HF Chip in einen Hohlleiter zu übertragen.

Die räumlich beispielsweise in unmittelbarer Nähe des Verbindungsbereiches angeordnete zweite Eintiefung kann somit vorteilhaft bei geringen Verlusten und kompakter mechanischer Implementierung dazu dienen, dass die Leiterplatte gleichzeitig auch die Erzeugung der hochfrequenten elektromagnetischen Signale sowie die Verarbeitung der empfangenen HF-Signale als Funktionseinheit implementieren kann. Dies kann den Vorteil haben, dass die technisch sensiblen Hochfrequenzbauteile kompakt und in sich abgeschlossen in einer Baugruppe vereinigt werden und somit weitestgehend von externen Einflüssen unabhängig sein können. Gemäß einem Beispiel kann der HF Chip auch ohne zweite Eintiefung auf dem Leiterplattensubstrat angeordnet sein. Gemäß einer Ausführungsform der Erfindung ist die zweite Eintiefung mit einem Kunstharz gefüllt. Dies kann vorteilhaft der mechanischen Stabilität sowie dem Schutz vor Umwelteinflüssen dienen.

Gemäß einem weiteren Aspekt der Erfindung wird ein Verfahren zur Erzeugung eines Resonators für Mikrowellen in einer Leiterplatte vorgestellt. Dieses Verfahren beinhaltet zunächst den Schritt des Bereitstellens eines nichtleitenden flächigen Leiterplattensubstrates. In einem nächsten Schritt wird auf einer Rückseite dieses Leiterplattensubstrates eine ringförmig umlaufende Eintiefung erzeugt. Diese kann gemäß einem Beispiel aus mehreren Teilstücken bestehen, kann aber vorzugsweise auch als geschlossener Ring ausgeführt sein. Danach erfolgt auf einer Wandung der Eintiefung und auf ein von der Eintiefung eingeschlossenen Bereich der Rückseite des Leiterplattensubstrates ein Aufbringen einer für mikrowellenreflektierende Beschichtung. Dies kann beispielsweise eine metallische Schicht sein, wobei im Stand der Technik verschiedene Verfahren zum Aufbringen von metallischen Schichten auf Oberflächen von Leiterplattensubstraten bekannt sind. In einem Beispiel ist nur eine Teilfläche der Wandung und/oder eine Teilfläche des von der Eintiefung eingeschlossenen Bereiches mit einer metallischen oder zumindest reflektierenden Beschichtung versehen.

In einem weiteren Schritt erfolgt ein Herstellen von Durchkontaktierungen zwischen einer Vorderseite des Leiterplattensubstrates und der reflektierenden Beschichtung in der Eintiefung, wobei die Durchkontaktierungen derart auf der Vorderseite angeordnet sind, dass eine Stirnseite des Hohlleiterendes elektrisch mit den Durchkontaktierungen verbindbar ist. Diese Durchkontaktierungen können beispielsweise als rohrförmige Bohrungen mit anschließender Metallisierung ausgeführt sein. In einer Ausführungsform des Verfahrens beinhaltet das Erzeugen der Eintiefung zusätzlich ein Abtragen von Leiterplattensubstrat zur Absenkung eines von der Eintiefung eingeschlossenen Bereiches in Richtung der Vorderseite.

Hierdurch kann beispielsweise die letztendliche Form und Dimension des Resonatortopfes, beispielsweise im Zuge einer elektromagnetischen Abstimmung, generiert werden. Dies kann gemäß einem Beispiel auch durch die Anpassung der Form und Größe der Eintiefung auf der Rückseite des Leiterplattensubstrates erfolgen.

In einer Ausführungsform des erfindungsgemäßen Verfahrens erfolgt das Erzeugen der Eintiefung und/oder des umgebenden Bereiches mittels Fräsen. Dieses Verfahren kann Effizienzvorteile bei gleichzeitig vergleichsweise genauer Erzeugung der gewünschten Formen bei den hier vorherrschenden geringen Abmessungen haben. Gemäß einer weiteren Ausführungsform des erfindungsgemäßen Verfahrens erfolgt ein Auffüllen der Eintiefung und/oder des von der Eintiefung eingeschlossenen Bereiches mit einem Kunstharz. Hierzu kann beispielsweise erwärmtes und flüssiges Kunstharz durch Gießverfahren oder Spritzverfahren, beispielsweise über einen Via-Filling-Prozess, auf das Leiterplattensubstrat aufgetragen werden und so die abgetragenen oder ausgefrästen Bereiche ausgeglichen werden. Vorteil ist hier eine verbesserte Stabilität, da Sollbruchstellen durch dünnere Stellen vermieden werden können und gleichzeitig das Kunstharz eine mechanisch stabile und dauerhafte Verbindung mit dem Leiterplattensubstrat eingehen kann.

Es ist zu verstehen, dass Merkmale des Verfahrens so wie obenstehend und untenstehend beschrieben auch Merkmale der Leiterplatte sein können und umgekehrt.

### Kurze Beschreibung der Figuren

Im Folgenden werden Ausführungsbeispiele der Erfindung mit Bezug auf die beiliegenden Figuren detailliert beschrieben. Weder die Beschreibung noch die Figuren sollen als die Erfindung einschränkend ausgelegt werden.
Fig. 1 zeigt einen Teilbereich einer erfindungsgemäßen Leiterplatte in Querschnittsdarstellung.
Fig. 2 zeigt eine räumliche Schnittdarstellung einer erfindungsgemäßen Leiterplatte mit einem Hohlleiter.
Fig. 3 zeigt eine Leiterplatte gemäß der Erfindung mit mehreren Leitungsebenen und einer zweiten Eintiefung.
Fig. 4 zeigt eine Leiterplatte gemäß der Erfindung in vereinfachter Ausführung ohne Leitungsebenen.
Fig. 5 zeigt eine Rückseite einer erfindungsgemäßen Leiterplatte mit einer kreisförmig umlaufenden Eintiefung und Durchkontaktierungen.
Fig. 6 zeigt eine Vorderseite einer erfindungsgemäßen Leiterplatte mit einem Kunststoff-Gehäuse und ausgespartem Bereich für einen Hohlleiter.
Fig. 7 zeigt ein erfindungsgemäßes Verfahren zur Erzeugung eines Resonators für Mikrowellen in einer Leiterplatte.

Die Zeichnungen sind lediglich schematisch und nicht maßstabsgetreu. Grundsätzlich sind identische oder ähnliche Teile mit den gleichen Bezugszeichen versehen.

### Detaillierte Beschreibung von Ausführungsbeispielen

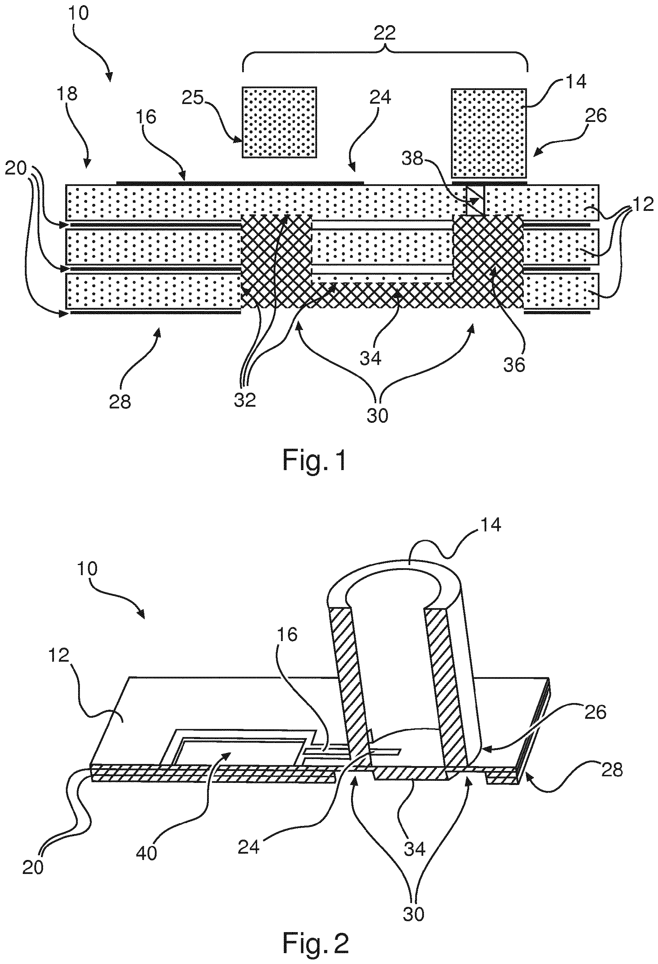

Fig. 1 zeigt einen Teilbereich einer erfindungsgemäßen Leiterplatte 10 zur Ankopplung eines Hohlleiters 14. Auf einem Leiterplattensubstrat 12 ist ein Mikrowellenleiter 16 angeordnet. Im hier gezeigten Beispiel verläuft der Mikrowellenleiter 16 auf einer Oberfläche des Leiterplattensubstrates 12, hier auf einer Vorderseite 18. Gemäß einem (hier nicht gezeigten) Beispiel ist der Mikrowellenleiter 16 in einem Inneren des Leiterplattensubstrates 12 geführt. Dies kann den Vorteil haben, dass entgegen der Darstellung in Fig. 1 keine zusätzliche Separierung oder Verkürzung des Hohlleiters 14 zum Zwecke der Isolation an dieser Stelle notwendig ist, sondern der Hohlleiter 14 einen umlaufenden planen bzw. flachen Abschluss mit dem Vorteil vereinfachter Herstellung (zum Beispiel Abschneiden) aufweisen kann.

Das Leiterplattensubstrat 12 ist aus einem HF-neutralen bzw. für Hochfrequenzen im betreffenden Bereich isolierenden Material, beispielsweise LCP oder ein PTFE-Substrat diverser Hersteller, gefertigt. Innerhalb des Leiterplattensubstrates 12 sind mehrere Leitungsebenen 20 angeordnet, um die entsprechenden elektrischen Verbindungen einer Elektronikschaltung abzubilden. Ein Verbindungsbereich 22 beschreibt den Bereich auf der Vorderseite 18 des Leiterplattensubstrates 12, dem der Hohlleiter 14 gegenüberliegt bzw. wo der Hohlleiter 14 mit dem Leiterplattensubstrat 12 verbunden ist. Diese Verbindungsbereich 22 ist ringförmig ausgestaltet, sodass dieser ein stirnseitiges Ende 26 des Hohlleiters 14 aufnehmen kann. Gemäß einem Beispiel ist der Verbindungsbereich 22 rechteckig ausgeführt. Somit ist beispielsweise der Anschluss von ebenfalls rechteckig ausgeführten Hohlleitern 14 möglich. Hierbei ist anzumerken, dass verschiedenste Querschnittsformen von Hohlleitern 14 und Verbindungsbereichen 22 möglich sind, wobei es sinnvoll ist, dass sich die Wandung des Hohlleiters 14 und der Verbindungsbereich 22 überlappen bzw. sich direkt gegenüberliegen.

Ein Ende des Mikrowellenleiters 24 ragt in den Verbindungsbereich 22 hinein, sodass Mikrowellensignale vom Mikrowellenleiter 16 bzw. über das Ende des Mikrowellenleiters 24 in den Hohlleiter 14 übergehen können und umgekehrt. Mit anderen Worten wirkt das Ende 24 des Mikrowellenleiters 16 wie eine Sende-und Empfangsantenne, die Mikrowellensignale in den Hohlleiter 14 aussendet und aus dem Hohlleiter 14 empfangen kann. Auf einer Rückseite 28 des Leiterplattensubstrates 12 ist gegenüber dem ringförmigen Verbindungsbereich 22 eine der Querschnittsfläche des Hohlleiters 14 entsprechende umlaufende Eintiefung 30 angeordnet. In den folgenden Figuren werden die räumlichen Ausgestaltungen dieser Eintiefung verdeutlicht.

An einer Wandung der Eintiefung 30 ist eine metallische Beschichtung 32 aufgebracht, die hier als gestrichelte Linie dargestellt ist. Grundsätzlich sind hier neben metallischen Beschichtungen auch andere Arten von Beschichtungen oder Stoffen allgemein möglich, die eine reflektierende Wirkung für Mikrowellen im hier relevanten Gigahertzbereich aufweisen. Hierzu können beispielsweise auch Fluide oder sogar Gase zählen, die entsprechende physikalische Eigenschaften oder Elemente wie beispielsweise Ionen aufweisen. Metallische Beschichtungen 32 können hier vorteilhaft sein, da sie mit bekannten Verfahren zu vergleichsweise geringen Kosten hergestellt werden können und gute reflektierende Wirkung entfalten. In einem Beispiel weist die Eintiefung 30 eine Breite von etwa 1 mm und eine Tiefe und Länge im Bereich von kleiner 1mm auf. Die Abmessungen orientieren sich dabei an dem verwendeten Frequenzbereich der Mikrowellen. Gemäß einem Beispiel beträgt eine Dicke einer metallischen Beschichtung 32 etwa wenige µm.

Ein abgesenkter Bereich 34 ist von der Eintiefung 30 umgeben und bildet zusammen mit der Eintiefung 30 auf seiner zur Vorderseite 18 gewandten Seite einen Resonator oder Resonatortopf im Zusammenwirken mit dem Hohlleiter 14. Der abgesenkte Bereich 34 kann auch ohne Absenkung gemäß einem Beispiel eine metallische Beschichtung 32 aufweisen. Die Absenkung hat hier den Vorteil, dass der sich ergebende Raum zusammen mit der Eintiefung mit einem Kunstharz 36 vergossen werden kann und so eine Stabilität der Leiterplatte 10 erhöht werden kann. Statt des Kunstharzes sind andere füllende und stabilisierende sowie haltbare Materialien wie Kunststoffe, Klebestoffe, Füllstoffe oder Ähnliches einsetzbar.

Im Leiterplattensubstrat 12 sind Durchkontaktierungen 38 vorgesehen, die derart angeordnet sind, dass sie eine elektrische Verbindung zwischen beispielsweise einer metallischen Wandung des Hohlleiters 14 und der metallischen Beschichtung 32 auf der Rückseite 28 des Leiterplattensubstrates 12 herstellen. Dies kann beispielsweise auch dadurch geschehen, dass die Durchkontaktierungen einen Teilbereich einer Leitungsebene 20 kontaktieren, die dann ihrerseits in elektrischem Kontakt mit dem Hohlleiter 14 steht. Dabei kann der Hohlleiter 14 durch verschiedene Mechanismen an der Leiterplatte 10 bzw. dem Leiterplattensubstrat 12 befestigt sein, beispielsweise durch Verlöten, Verschweißen oder Verkleben.

In Fig. 2 ist eine erfindungsgemäße Leiterplatte 10 mit einem Hohlleiter 14 in einer Schnittdarstellung dargestellt. Ein Leiterplattensubstrat 12 weist mehrere Leitungsebenen 20 auf. Auf einer Rückseite 28 des Leiterplattensubstrates 12 ist eine ringförmig umlaufende Eintiefung 30 eingebracht. Hier ist gut zu erkennen, dass die Eintiefung gegenüber einem stirnseitigen Ende 26 des Hohlleiters 14 auf der Rückseite 28 des Leiterplattensubstrates 12 verläuft. Ein Durchmesser eines abgesenkten Bereiches 34 entspricht hier in etwa einem Innendurchmesser des Hohlleiters 14. Das Ende 24 eines Mikrowellenleiters 16 ragt in das Innere des Hohlleiters 14 und wird dabei isoliert von der Wandung des Hohlleiters 14 geführt. In der Wandung des Hohlleiters 14 kann hierfür beispielsweise eine Aussparung vorgesehen sein. Gemäß einem weiteren Beispiel ist der Mikrowellenleiter 16 innerhalb des Leiterplattensubstrates geführt, was die Notwendigkeit einer Aussparung erübrigen kann.

In einem weiteren Bereich der Vorderseite 18 des Leiterplattensubstrates 12 ist eine zweite Eintiefung 40 zur Aufnahme eines HF-Chips (nicht gezeigt) vorgesehen. Insbesondere durch die inverse oder rückseitige Herstellung des Resonators durch die Eintiefung 30 und die metallische Beschichtung 32 lässt sich der Mikrowellenleiter 16 vorteilhaft in den Verbindungsbereich 22 bzw. den Innenbereich des Hohlleiters 14 führen. Dies kann eben dadurch vorteilhaft eine benachbarte Anordnung einer Hochfrequenzelektronik ermöglichen und so platzsparend implementieren. Die zweite Eintiefung 40 kann mit einem Kunstharz vergossen werden und so mechanische Stabilität und Zuverlässigkeit erhöhen.

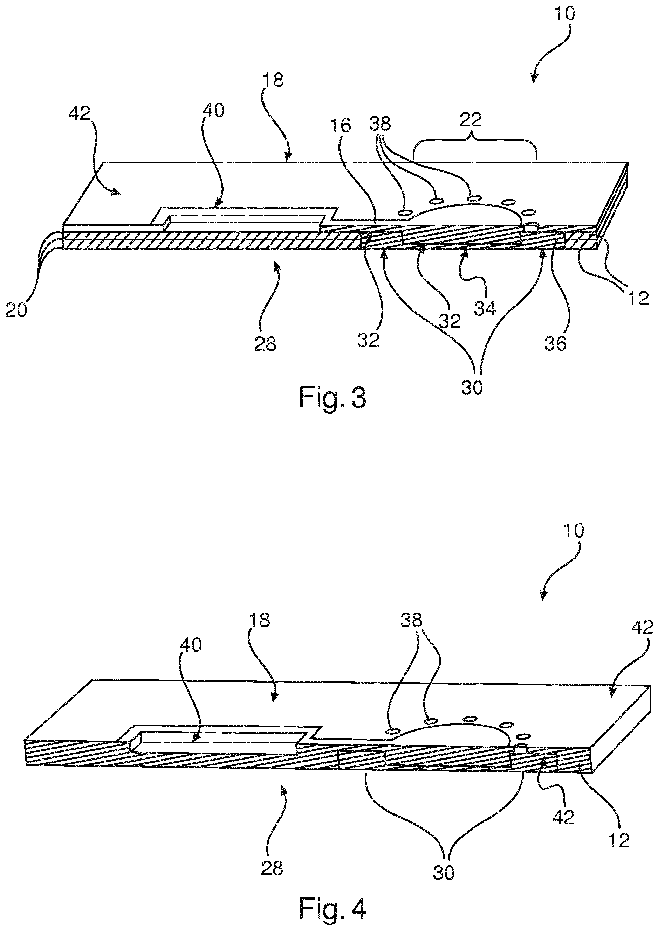

In Fig. 3 ist eine weitere beispielhafte Ausführungsvariante einer erfindungsgemäßen Leiterplatte 10 mit einem Leiterplattensubstrat 12 und mit mehreren Leitungsebenen 20 gezeigt. Auch in diesem Beispiel ist auf einer Rückseite 28 des Leiterplattensubstrates 12 eine mit Kunstharz 36 ausgefüllte Eintiefung 30 vorhanden, die einen Resonator für einen auf der gegenüberliegenden Vorderseite 18 anschließen Hohlleiter (nicht gezeigt) bildet. Ein Mikrowellenleiter 16 verläuft zwischen einer zweiten Eintiefung 40 und einem Verbindungsbereich 22. Durchkontaktierungen 38 dienen der Herstellung einer elektrischen Verbindung zwischen einer metallischen Beschichtung 32 in der Eintiefung 30 mit dem von der Eintiefung umgebenen abgesenkten Bereich 34 und einem anschließbaren Hohlleiter 14 (nicht gezeigt). In einem Beispiel sind zwei benachbarte Durchkontaktierungen 38 in einem Abstand voneinander angeordnet, der kleiner ist als ein Viertel der Wellenlänge der Mikrowellen. Dadurch kann verhindert werden, dass Mikrowellen zwischen den Durchkontaktierungen austreten und somit ungewollte Verluste auftreten.

In Fig. 4 ist eine vereinfachte Variante einer erfindungsgemäßen Leiterplatte 10 dargestellt, mit einem Leiterplattensubstrat 12 ohne Leitungsebenen 20. Dies kann erlauben, dass einfach ausgestaltete und somit preiswerte Ausgangsmaterialien für das Leiterplattensubstrat 12 verwendet werden können. Zu Zwecken der Abschirmung kann auf einer Vorderseite 18 des Leiterplattensubstrates 12 eine metallische Schicht 42 aufgetragen sein. Auch hier sind die Durchkontaktierungen 38 zu erkennen, die eine metallische Schicht 42 mit der Vorderseite 18 des Leiterplattensubstrates 12 elektrisch verbinden.

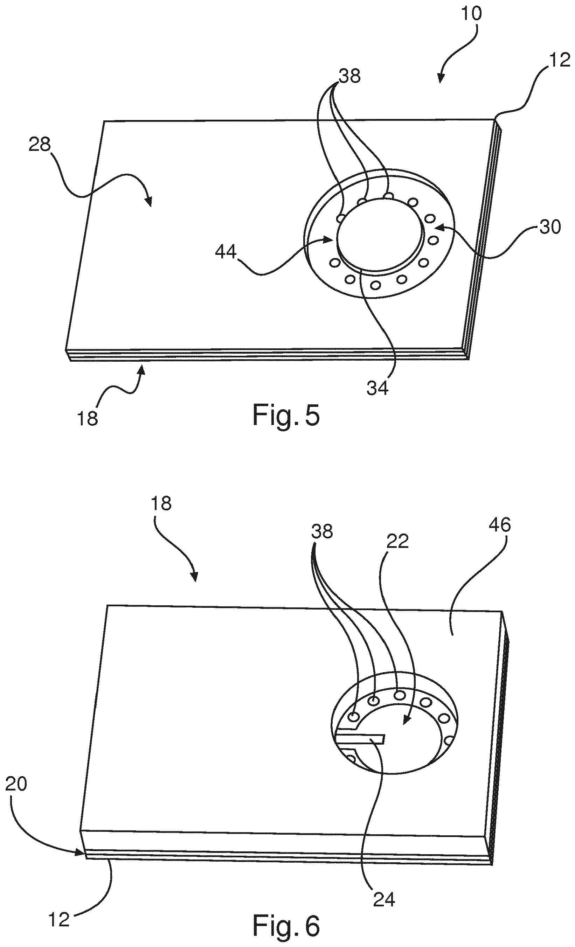

Fig. 5 zeigt ein vereinfacht dargestelltes Beispiel einer erfindungsgemäßen Leiterplatte 10, wobei hier eine Ansicht einer Rückseite 28 eines Leiterplattensubstrates 12 dargestellt ist. Gut zu erkennen ist eine kreisförmig gestaltete umlaufende Eintiefung 30, die einen abgesenkten Bereich 34 einschließt. Dabei sind Durchkontaktierungen 38 ebenfalls kreisförmig in der Eintiefung 30 angeordnet. In dem Bereich, wo ein Mikrowellenleiter (nicht dargestellt) auf einer Vorderseite 18 des Leiterplattensubstrates 12 in den umseitig vom abgesenkten Bereich 34 befindlichen Verbindungsbereich (hier nicht sichtbar) geführt wird, ist ein größerer Zwischenraum 44 zwischen den Durchkontaktierungen 38 zur Durchführung des Mikrowellenleiters 16 angeordnet.

In Fig. 6 ist ein Ausführungsbeispiel einer erfindungsgemäßen Leiterplatte 10 gezeigt, die ein Leiterplattensubstrat 12 mit mehreren Leitungsebenen 20 aufweist. Eine hier sichtbare Vorderseite 18 des Leiterplattensubstrates 12 ist mit einem Kunststoff 46 umgeben, dass durch seine stabilisierende Wirkung als Gehäuse dient. Dabei ist der Verbindungsbereich 22 mit Durchkontaktierungen 38 und einem Ende eines Mikrowellenleiters 24 derart ausgespart, dass ein rohrförmiger Hohlleiter 14 (nicht gezeigt) auf der Vorderseite 18 des Leiterplattensubstrates mit den Durchkontaktierungen 38 befestigt werden kann. In einem Beispiel ist die Leiterplatte als Land-Grid-Array (LGA) ausgeführt. Dazu können gemäß einem Beispiel die Anschlüsse eines HF-Chips über Leitungen und Durchkontaktierungen von Bondpads auf die Rückseite 28 des Leiterplattensubstrates 12 geführt sein und dort beispielsweise an Lötpads (nicht gezeigt) angeschlossen werden.

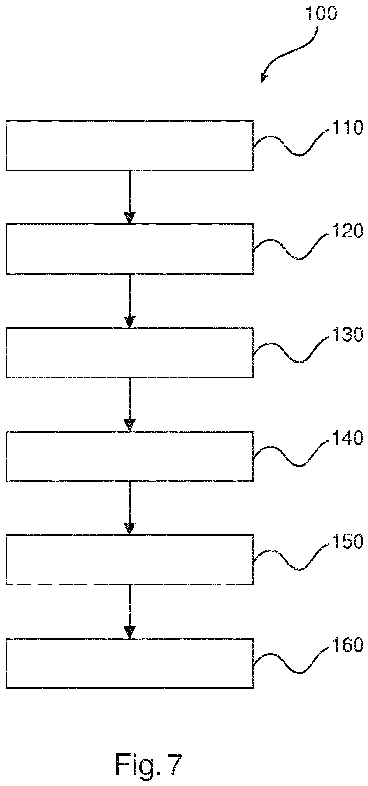

In Fig. 7 ist ein Verfahren 100 gemäß der Erfindung zur Erzeugung eines Resonators für Mikrowellen in einer Leiterplatte 10 beispielhaft gezeigt. Zunächst erfolgt ein Bereitstellen 110 eines nichtleitenden flächigen Leiterplattensubstrates 12. Auf einer Rückseite 28 des Leiterplattensubstrates 12 erfolgt im nächsten Schritt 120 ein Erzeugen einer ringförmig umlaufenden Eintiefung 30. Dies kann beispielsweise durch Fräsen oder ähnliche Verfahren erfolgen. In einem folgenden Schritt 130 erfolgt ein Aufbringen einer für Mikrowellen reflektierenden Beschichtung in dieser Eintiefung 30 und auf einen von der Eintiefung 30 eingeschlossenen Bereich 34 (abgesenkter Bereich) auf der Rückseite 28 des Leiterplattensubstrates 12. In einem Beispiel ist die reflektierende Beschichtung eine metallische Beschichtung 32.

Gemäß einem Beispiel ist die reflektierende Beschichtung der Eintiefung 30 und die reflektierende Beschichtung des abgesenkten Bereiches 34 auf der Rückseite 28 miteinander elektrisch verbunden. Danach wird in einem Schritt 140 ein Herstellen von Durchkontaktierungen 38 vollzogen. Diese verlaufen zwischen der Vorderseite 18 des Leiterplattensubstrates 12 und der reflektierenden Beschichtung bzw. metallischen Schicht 42 in der Eintiefung 30, wobei die Durchkontaktierungen 30 so auf der Vorderseite 18 angeordnet sind, dass eine Stirnseite eines Hohlleiters 14 elektrisch mit den Durchkontaktierungen 38 verbindbar ist. Optional kann zusätzlich ein Schritt 150 des selektiven Abtragens von Leiterplattensubstrat (12) zur Absenkung eines von der Eintiefung 30 eingeschlossenen Bereiches 32 in Richtung der Vorderseite 18 erfolgen. Dies kann beispielsweise durch Fräsen erfolgen. Die Eintiefung 30 und/oder der von der Eintiefung eingeschlossene Bereich kann im Schritt 160 mit einer reflektierenden Beschichtung überzogen werden und durch Auffüllen mit einem Kunstharz stabilisiert werden. Dies kann beispielsweise durch einen Via-Filling-Prozess erfolgen.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Leiterplatte (10) für ein Radar-Füllstandmessgerät, aufweisend
- ein nichtleitendes flächiges Leiterplattensubstrat (12);
- einen auf dem Leiterplattensubstrat (12) angeordneten Mikrowellenleiter (16) zur Einkopplung eines Mikrowellensignals in einen Hohlleiter (14);
wobei auf einer Vorderseite (18) des Leiterplattensubstrates (12) ein umlaufender Verbindungsbereich (22) zur Aufnahme eines stirnseitigen Endes (26) eines Hohlleiters (14) angeordnet ist;
wobei ein Ende des Mikrowellenleiters (24) in den Verbindungbereich (22) hineinragt, sodass Mikrowellensignale vom Mikrowellenleiter (16) in den Hohlleiter (14) übergehen können und umgekehrt;
wobei auf einer Rückseite (28) des Leiterplattensubstrates (12) gegenüber dem Verbindungsbereich (22) eine umlaufende Eintiefung (30) in Richtung des Hohlleiters (14) angeordnet ist;
wobei die Wandung der Eintiefung (30) und ein von der Eintiefung (30) umgebener Bereich (34) der Rückseite (28) des Leiterplattensubstrates (12) eine für Mikrowellen reflektierende Beschichtung (32) aufweisen, sodass diese zusammen einen Resonator für die eingekoppelten Mikrowellensignale bilden.

2. Leiterplatte (10) gemäß Anspruch 1, wobei die reflektierende Beschichtung (32) als metallische Beschichtung ausgeführt ist.

3. Leiterplatte (10) gemäß einem der Ansprüche 1 oder 2, wobei im Bereich der Eintiefung Durchkontaktierungen (38) zwischen der Vorderseite (18) und der metallischen Beschichtung (32) angeordnet sind, sodass die metallische Beschichtung (32) mit dem Hohlleiter (14) elektrisch verbindbar ist.

4. Leiterplatte (10) gemäß Anspruch 3, wobei ein Abstand zwischen zwei benachbarten Durchkontaktierungen (38) kleiner als ein Viertel der Wellenlänge der Mikrowellen ist.

5. Leiterplatte (10) gemäß einem der vorhergehenden Ansprüche, wobei der von der Eintiefung (30) eingeschlossene Bereich der Rückseite (28) in Richtung der Vorderseite (18) abgesenkt ist.

6. Leiterplatte (10) gemäß einem der vorhergehenden Ansprüche, wobei die Eintiefung (30) und/oder der von der Eintiefung (30) eingeschlossene Bereich mit einem anderen Material aufgefüllt ist.

7. Leiterplatte (10) gemäß einem der vorhergehenden Ansprüche, wobei der Verbindungsbereich und die Eintiefung kreisförmig ausgestaltet sind.

8. Leiterplatte (10) gemäß einem der vorhergehenden Ansprüche, wobei der Verbindungsbereich (22) und die Eintiefung (30) eine rechteckige Form aufweisen.

9. Leiterplatte (10) gemäß einem der vorhergehenden Ansprüche, wobei die Leiterplatte (10) auf der Vorderseite des Leiterplattensubstrates (12) eine zweite Eintiefung (40) zur Aufnahme eines HF-Chips aufweist und der Mikrowellenleiter (16) zwischen der zweiten Eintiefung (30) und dem Verbindungsbereich (22) verläuft.

10. Leiterplatte (10) gemäß Anspruch 9, wobei die zweite Eintiefung (40) mit einem Kunstharz gefüllt ist.

11. Radarfüllstandmessgerät mit einer Leiterplatte (10) gemäß einem der Ansprüche 1 bis 10.

12. Verfahren (100) zur Erzeugung eines Resonators für Mikrowellen in einer Leiterplatte (10), aufweisend die Schritte:
- Bereitstellen (110) eines nichtleitenden flächigen Leiterplattensubstrates (12);
- Erzeugen (120) einer umlaufenden Eintiefung (30) auf einer Rückseite (28) des Leiterplattensubstrates (12);
- Aufbringen (130) einer für Mikrowellen reflektierenden Beschichtung (32) auf eine Wandung der Eintiefung (30) und auf einen von der Eintiefung (30) eingeschlossenen Bereich (34) der Rückseite (28) des Leiterplattensubstrates (12);
- Herstellen (140) von Durchkontaktierungen (38) zwischen einer Vorderseite (18) des Leiterplattensubstrates (12) und der reflektierenden Beschichtung (32) in der Eintiefung, wobei die Durchkontaktierungen (38) derart auf der Vorderseite (18) angeordnet sind, dass eine Stirnseite eines Hohlleiterendes (26) elektrisch mit den Durchkontaktierungen (38) verbindbar ist.

13. Verfahren (100) gemäß Anspruch 12, wobei das Erzeugen (120) der Eintiefung (30) zusätzlich ein Abtragen (150) von Leiterplattensubstrat (12) zur Absenkung eines von der Eintiefung (30) eingeschlossenen Bereiches (34) in Richtung der Vorderseite (18) beinhaltet.

14. Verfahren (100) gemäß Anspruch 12 oder 13, wobei das Erzeugen (120) der Eintiefung (30) und/oder des umgebenen Bereiches (34) mittels Fräsen oder mittels Laser erfolgt.

15. Verfahren (100) gemäß einem der Ansprüche 12 bis 14, weiterhin aufweisend den Schritt:
- Auffüllen (160) der Eintiefung (30) und/oder des von der Eintiefung (30) eingeschlossenen Bereiches (34) mit einem anderen Material.

## Claims

1. A printed circuit board (10) for a radar fill level measurement device, comprising
- a non-conductive planar printed circuit board substrate (12);
- a microwave conductor (16), configured to couple a microwave signal into a waveguide (14) arranged on the printed circuit board substrate (12);
wherein on a front side (18) of the printed circuit substrate (12), a circumferential connecting region (22), configured to receive a front-side end (26) of a waveguide (14), is arranged;
wherein one end of the microwave conductor (24) projects into the connection region (22) so that microwave signals can pass from the microwave conductor (16) into the waveguide (14) and vice versa;
wherein on a rear side (28) of the printed circuit board substrate (12) opposite to the connecting region (22), a circumferential recess (30) in the direction of the waveguide (14) is arranged;
wherein the wall of the recess (30) and a region (34) of the rear side (28) of the printed circuit board substrate (12) surrounded by the recess (30) comprise a microwave-reflective coating (32), so that they form together a resonator for the injected microwave signals.

2. The printed circuit board (10) according to claim 1, wherein the reflective coating (32) is designed as a metallic coating.

3. The printed circuit board (10) according to one of claims 1 or 2, wherein plated-through holes (38) are arranged in the region of the recess between the front side (18) and the metallic coating (32), so that the metallic coating (32) is electrically connectable to the waveguide (14).

4. The printed circuit board (10) according to claim 3, wherein a distance between two adjacent plated-through holes (38) is less than a quarter of the wavelength of the microwaves.

5. The printed circuit board (10) according to any of the preceding claims, wherein the region of the rear side (28) enclosed by the recess (30) is lowered towards the front side (18).

6. The printed circuit board (10) according to any of the preceding claims, wherein the recess (30) and / or the region enclosed by the recess (30) is filled with another material.

7. The printed circuit board (10) according to any of the preceding claims, wherein the connecting region and the recess are designed circular.

8. The printed circuit board (10) according to any of the preceding claims, wherein the connecting region (22) and the recess (30) have a rectangular shape.

9. The printed circuit board (10) according to any of the preceding claims, wherein the printed circuit board (10) on the front side of the printed circuit board substrate (12) comprises a second recess (40) for receiving a HF chip and the microwave conductor (16) extends between the second recess (30) and the connection region (22).

10. The printed circuit board (10) according to claim 9, wherein the second recess (40) is filled with a synthetic resin.

11. Radar fill level measuring device with a printed circuit board (10) according to any of claims 1 to 10.

12. A method (100) for generating a resonator for microwaves in a printed circuit board (10), comprising the steps:
- providing (110) a non-conductive planar printed circuit board substrate (12);
- generating (120) a circumferential recess (30) on a rear side (28) of the printed circuit board substrate (12);
- applying (130) a microwave reflective coating (32) on a wall of the recess (30) and on a region (34) of the rear side (28) of the printed circuit board substrate (12) enclosed by the recess (30);
- producing (140) plated-through holes (38) between a front side (18) of the printed circuit board substrate (12) and the reflective coating (32) in the recess, wherein the plated-through holes (38) are arranged on the front side (18) such that a face side of a waveguide end (26) is electrically connectable to the plated-through holes (38).

13. The method (100) of claim 12, wherein generating (120) the recess (30) further comprises removing (150) circuit board substrate (12) for lowering a region (34) enclosed by the recess (30) toward the front side (18).

14. The method (100) according to claim 12 or 13, wherein the generating (120) of the recess (30) and / or the surrounding region (34) is carried out by means of milling or by means of laser.

15. The method (100) according to any of claims 12 to 14, further comprising the step:
- filling (160) the recess (30) and / or the region enclosed by the recess (30) with another material.

## Revendications

1. Carte de circuits imprimés (10) pour un appareil de mesure de niveau de remplissage radar, comportant :
- un substrat (12) de carte de circuits imprimés plan non conducteur ;
- un guide de micro-ondes (16) disposé sur le substrat (12) de carte de circuits imprimés pour le couplage d'un signal micro-ondes dans un guide d'ondes (14) ;
une zone de liaison (22) périphérique destinée à recevoir une extrémité (26) frontale d'un guide d'ondes (14) étant disposée sur une face avant (18) du substrat (12) de carte de circuits imprimés ;
une extrémité du guide de micro-ondes (24) dépassant dans la zone de liaison (22), de telle sorte que des signaux micro-ondes peuvent passer du guide de micro-ondes (16) au guide d'ondes (14) et inversement ;
un renfoncement (30) périphérique en direction du guide d'ondes (14) étant disposé sur une face arrière (28) du substrat (12) de carte de circuits imprimés en face de la zone de liaison (22) ;
la paroi du renfoncement (30) et une zone (34) entourée par le renfoncement (30) et située sur la face arrière (28) du substrat (12) de carte de circuits imprimés comportant un revêtement (32) réfléchissant pour les micro-ondes, de telle sorte qu'elles forment ensemble un résonateur pour les signaux micro-ondes couplés.

2. Carte de circuits imprimés (10) selon la revendication 1, le revêtement (32) réfléchissant étant réalisé sous la forme d'un revêtement métallique.

3. Carte de circuits imprimés (10) selon la revendication 1 ou 2, dans laquelle des vias (38) sont disposés entre la face avant (18) et le revêtement (32) métallique dans la zone du renfoncement, de telle sorte que le revêtement (32) métallique peut être relié électriquement au guide d'ondes (14) .

4. Carte de circuits imprimés (10) selon la revendication 3, dans laquelle une distance entre deux vias (38) voisins est inférieure à un quart de la longueur d'onde des micro-ondes.

5. Carte de circuits imprimés (10) selon l'une des revendications précédentes, dans laquelle la zone de la face arrière (28) qui est entourée par le renfoncement (30) est abaissée en direction de la face avant (18).

6. Carte de circuits imprimés (10) selon l'une des revendications précédentes, dans laquelle le renfoncement (30) et/ou la zone entourée par le renfoncement (30) est rempli(e) d'un autre matériau.

7. Carte de circuits imprimés (10) selon l'une des revendications précédentes, dans laquelle la zone de liaison et le renfoncement sont conçus de forme circulaire.

8. Carte de circuits imprimés (10) selon l'une des revendications précédentes, dans laquelle la zone de liaison (22) et le renfoncement (30) présentent une forme rectangulaire.

9. Carte de circuits imprimés (10) selon l'une des revendications précédentes, dans laquelle la carte de circuits imprimés (10) comporte, sur la face avant du substrat (12) de carte de circuits imprimés, un second renfoncement (40) destiné à recevoir une puce HF et le guide de micro-ondes (16) s'étend entre le second renfoncement (40) et la zone de liaison (22).

10. Carte de circuits imprimés (10) selon la revendication 9, dans laquelle le second renfoncement (40) est rempli d'une résine synthétique.

11. Appareil de mesure de niveau de remplissage radar doté d'une carte de circuits imprimés (10) selon l'une des revendications 1 à 10.

12. Procédé (100) destiné à réaliser un résonateur pour micro-ondes dans une carte de circuits imprimés (10), comportant les étapes :
- fourniture (110) d'un substrat (12) de carte de circuits imprimés plan non conducteur ;
- réalisation (120) d'un renfoncement (30) périphérique sur une face arrière (28) du substrat (12) de carte de circuits imprimés ;
- application (130) d'un revêtement (32) réfléchissant pour les micro-ondes sur une paroi du renfoncement (30) et sur une zone (34) de la face arrière (28) du substrat (12) de carte de circuits imprimés, qui est entourée par le renfoncement (30) ;
- fabrication (140) de vias (38) entre une face avant (18) du substrat (12) de carte de circuits imprimés et le revêtement (32) réfléchissant dans le renfoncement, les vias (38) étant disposés sur la face avant (18) de telle manière qu'une face frontale d'une extrémité de guide d'ondes (26) peut être reliée électriquement aux vias (38).

13. Procédé (100) selon la revendication 12, dans lequel la réalisation (120) du renfoncement (30) inclut en plus un enlèvement (150) de substrat (12) de carte de circuits imprimés pour l'abaissement d'une zone (34) entourée par le renfoncement (30) en direction de la face avant (18).

14. Procédé (100) selon la revendication 12 ou 13, dans lequel la réalisation (120) du renfoncement (30) et/ou de la zone (34) entourée est effectuée par fraisage ou par laser.

15. Procédé (100) selon l'une des revendications 12 à 14, comportant en outre l'étape :
- remplissage (160) du renfoncement (30) et/ou de la zone (34) entourée par le renfoncement (30) avec un autre matériau.
